# EUROPEAN PATENT SPECIFICATION

(11) **EP 1 718 474 B1**
(45) Date of publication and mention of the grant of the patent: **20.04.2011**
(21) Application number: 05724049.1
(22) Date of filing: 24.02.2005
(51) Int. Cl.: G03F 1/00, B41N 1/14

(54) **COMBINED ABLATION AND EXPOSURE SYSTEM AND METHOD**
KOMBINIERTES ABLATIONS- UND BELICHTUNGSSYSTEM UND VERFAHREN
SYSTEME ET PROCEDE COMBINE D'ABLATION ET D'EXPOSITION

(30) Priority: 25.02.2004 US 547652 P; 09.04.2004 US 821453
(43) Date of publication of application: 08.11.2006
(73) Proprietor: Esko-Graphics Imaging GmbH, 25524 Itzehoe (DE)
(72) Inventor: HULL, Frank A., c/o CORTRON CORPORATION, Minneapolis, Minnesota 55432 (US); HORRISBERGER, Benn, c/o CORTRON CORPORATION, Minnepolis, Minnesota 55432 (US)
(74) Representative: Elsworth, Dominic Stephen
(86) International application number: PCT/US2005/006422
(87) International publication number: WO 2005/082097

(56) References cited:
- JP-A- 9 139 190
- US-A- 4 304 842
- US-A- 4 868 090
- US-A- 5 540 150
- US-A- 5 760 880
- US-B1- 6 180 325
- US-B1- 6 700 598

## Description

### BACKGROUND OF THE INVENTION

The present invention relates to ablation and exposure of flexographic printing plates, and more particularly to a system and method of exposing a flexographic plate on a rotating cylinder that is also used to ablate the plate.

Digital flexographic printing plates are conventionally imaged in two steps. The first step is to ablate the plate in a pattern that defines a mask on the plate. The mask represents the graphical image that the plate is used to print. This step is typically performed by placing the plate on a rotating cylinder and ablating the plate with a linearly movable imaging source controlled to ablate the desired image into the overcoat of the plate. The second step of the process is to expose the thereby masked plate to high intensity light, which results in a plate that is ready for processing. This step is typically performed by placing the masked plate on a flatbed and flooding the plate with high intensity light. In some systems, stationary light assemblies are used to expose cylindrically mounted photosensitive plates, such as those disclosed in U.S. Patent No. 4,868,090 to Kitamura et al. and U.S. Patent No. 4,304,842 to Schoute.

In the conventional two step process, great care must be taken in handling the plate after it has been ablated and before it has been exposed, as the carbon on the plate can be easily scratched or otherwise blemished in a way that renders useless the image represented on the plate. Flexographic plates are expensive, and losing plates due to corruption resulting from handling is therefore quite undesirable. In addition, flexographic plates can also be quite large in some applications, requiring a very large flatbed exposure device which can also be quite expensive.

One approach to solving this problem has been to provide an exposing apparatus that is integrated into the ablation system. A light source such as a compact arc lamp is provided that is movable along the cylinder on which the plate is placed, exposing the plate after it is ablated as it rotates on the cylinder. An example of such a system is disclosed in U.S. Patent No. 6,180,325 to Gelbart. This system has not been successful for a number of reasons, including the geometry of the light source and its inability to provide sufficient power to effectively expose the plate, the effect of exposure latency when a point on the plate rotates out of the field of illumination of the light source, and others.

There is a need in the art for an effective apparatus and method to expose masked flexographic printing plates without having to handle the plates between the processes of ablation and exposure.

### SUMMARY OF THE INVENTION

The present invention is an exposure system that surrounds a photopolymer on a rotating cylinder ablation system. The exposure system linearly follows the ablation source and operates to expose the ablated (masked) plate with high intensity illumination to expose all points on the photopolymer. The exposure system employs at least one plasma capillary light source configured to illuminate the photopolymer with high intensity light.

### BRIEF DESCRIPTION OF THE DRAWINGS

FIG. 1A is a perspective diagram, and FIG. 1B is a side view, of an exposure system according to a first embodiment of the present invention.
FIG. 2 is a perspective diagram illustrating the operation of the exposure system shown in FIGS. 1A and 1B in conjunction with an ablation system according to the first embodiment of the present invention.
FIG, 3 is a cross-sectional view of the exposure system shown in FIGS. 1A and 1B, taken along line 3-3 of FIG. 1B.
FIG. 4 is a front view of the exposure system shown in FIG. 1A, with a portion shown in section.
FIG. 5 is an enlarged view of the portion of FIG. 4 that is shown in section, illustrating the configuration of each of the individual high intensity light sources provided around the circumference of the body of the exposure system.
FIG. 6 is a perspective diagram of a combined ablation and exposure system
FIG. 7 is a side view of the combined ablation and exposure system shown in FIG. 6.
FIG. 8 is a diagram illustrating an exemplary light source assembly for use in the combined ablation and exposure system shown in FIGS. 6 and 7.

### DETAILED DESCRIPTION

The present invention provides an exposure system that at least partially surrounds a photopolymer such as a flexographic plate in a rotating cylinder ablation system, the exposure system linearly following the ablation source and operating to expose the ablated (masked) plate with high intensity illumination. The flexographic printing plate may be mounted to a rotating cylinder, or may itself be a cylindrical sleeve type of plate. The invention is described below with respect to two exemplary embodiments.

### First Embodiment

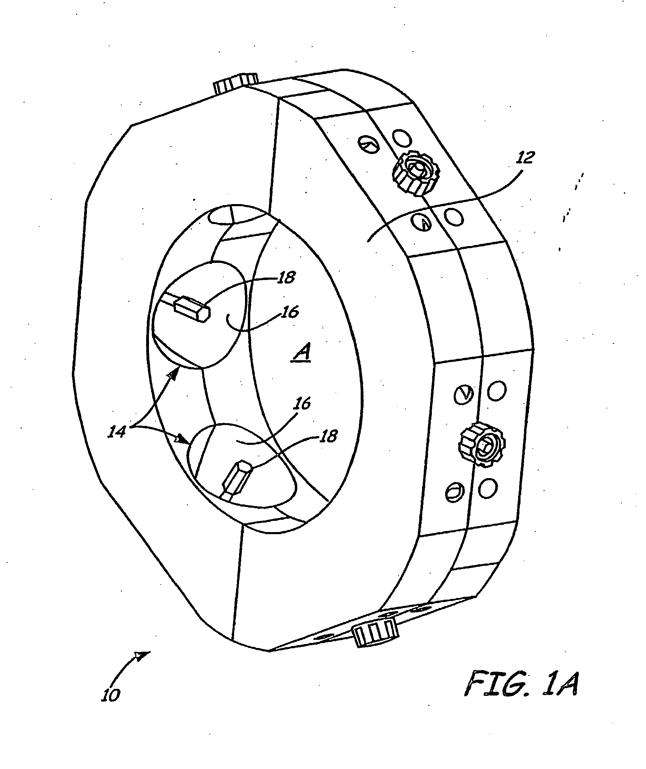

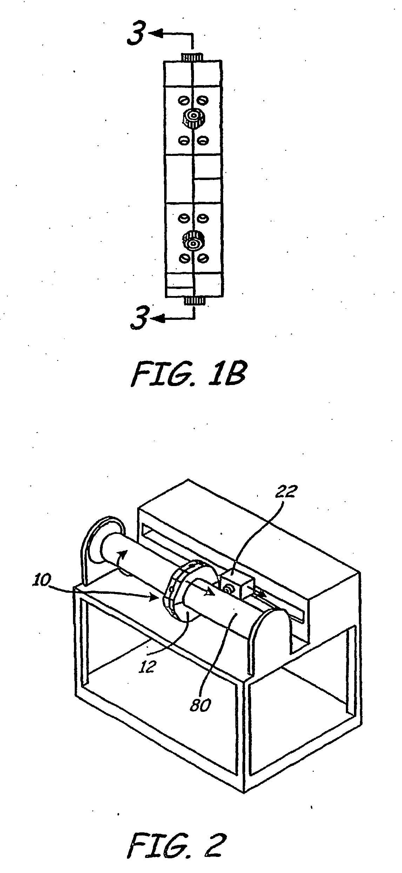

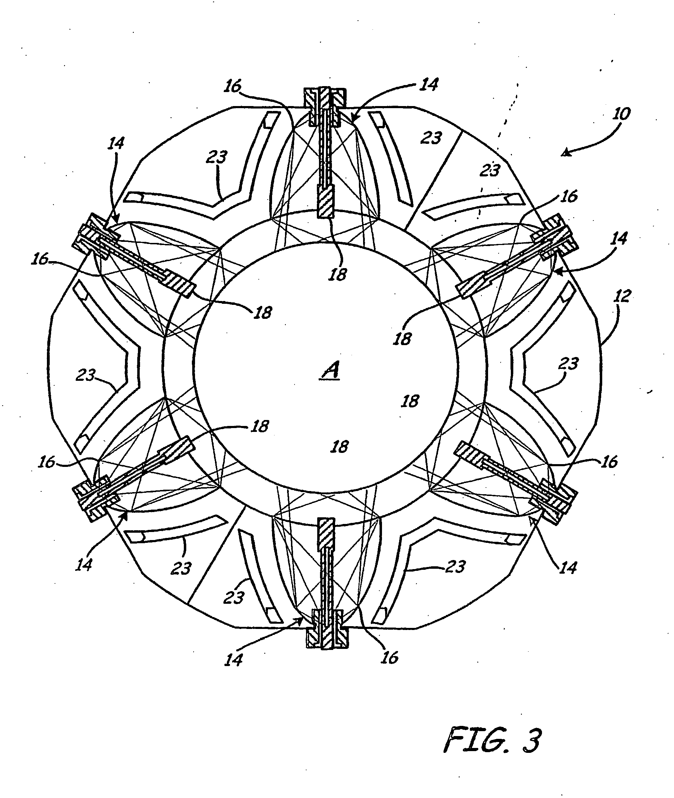

FIG. 1A is a perspective diagram, and FIG. 1B is a side view, of exposure system 10 according to a first embodiment of the present invention. Body 12, having a toroidal geometry and being made of a material such as aluminum for example, is provided to surround a rotating cylinder (not shown in FIG. 1, but which fits inside aperture A) on which a flexographic plate is mounted. A plurality of high intensity light sources 14 are provided in body 12, each of which is operable to direct high intensity light inward toward the flexographic plate mounted on the rotating cylinder within aperture A. The entire assembly of body 12 and light sources 14 is watercooled by chambers (shown in FIG. 3) within body 12. Each light source 14 includes a reflector 16 surrounding a lamp 18, where reflectors 16 are dichroic coated to selectively reflect the light spectrum (ultraviolet light) req uired to polymerize the flexographic plate. The remaining light emission is absorbed into the liquid cooled body 12.

FIG. 2 is a perspective diagram illustrating the operation of exposure system 10 in conjunction with an ablatio in system according to the first embodiment of the present invention. In operation, the entire body 12 of exposure system 10 is linearly moved along the length of the flexographic plate being ablated on rotating cylinder 20 (within aperture A (FIG. 1A)), so that body 12 follows ablating engine 22 and serves to expose ablated portions of the plate with high intensity light. Light sources 14 (FIG. 1A) are configured and arranged so that their high intensity light outputs overlap one another, so that all points of the flexographic plate are continuously exposed by at least one of light sources 14. This is in contrast to prior single-lamp systems in which any particular point on the plate is exposed to light in a pulsing pattern, which results in a problem known as latency in which each point is not efficiently exposed due to the low duty cycle of light impinging on the point. Continuous exposure is considerably more effective in exposing the plate properly than the pulsing exposure achieved by the prior art.

FIG. 3 is a cross-sectional view of exposure system 10 taken along line 3-3 of FIG. 1B. FIG. 3 illustrates the paths of light rays produced by light sources 14 in the body 12 of exposure system 10, showing how the light produced by lamps 18 is reflected by parabolic reflectors 16. FIG. 3 also shows the configuration of chambers 23 in body 12, which form a path for the flow of cooling liquid to cool heat produced by light sources 14. As shown in FIG. 3, there are six light sources 14 around the circumference of body 12 in an exemplary embodiment, although there could be more or fewer in alternative configurations. In addition, an alternative configuration may employ fewer light sources (as few as one in some embodiments), with the output(s) of the light source(s) being piped or otherwise directed to a plurality of light outputs so that continuous exposure of all points of the flexographic plate is achieved.

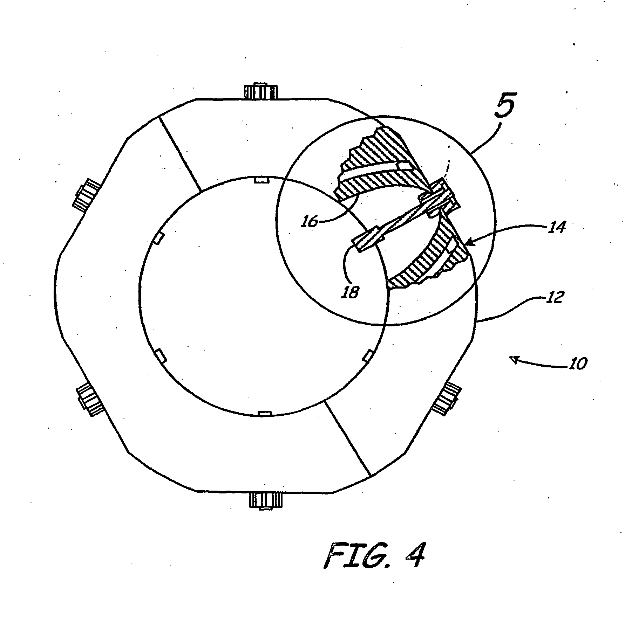

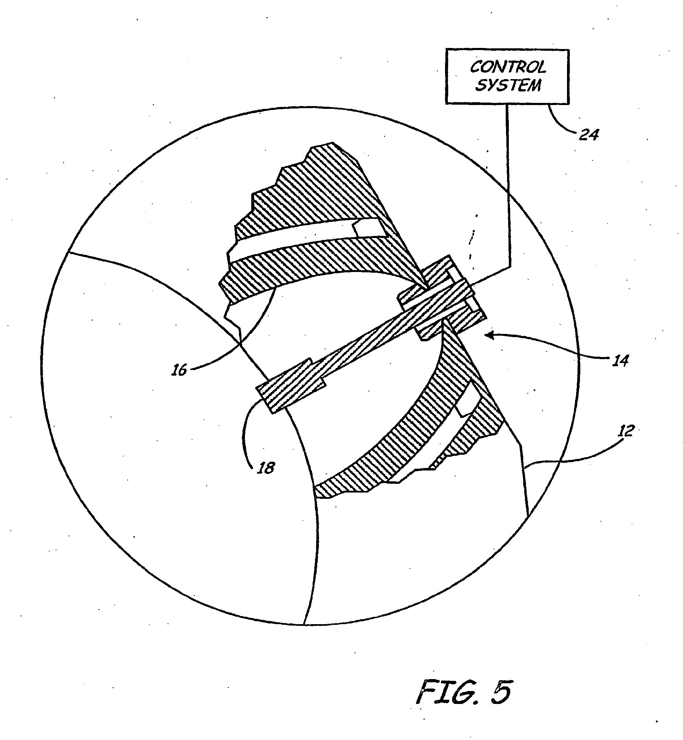

FIG. 4 is a front view of the exposure system 10 shown in FIG. 1A, with a portion shown in section, and FIG. 5 is an enlarged view of the portion of FIG. 4 that is shown in section. FIGS. 4 and 5 illustrate the configuration of each of the individual high intensity light sources 14 provided around the circumference of body 12 of exposure system 10. In an exemplary embodiment, light source 14 includes lamp 18 that is a 1000 Watt Mercury plasma capillary lamp, located in parabolic reflector 16 that is coated with a dichroic coating on its inner surface so that actinic (ultraviolet) radiation is reflected and all other (non-useful) radiation is absorbed. In other embodiments, a different element such as Xenon, Lead, or another element capable of producing actinic radiation may be used in addition to or in place of Mercury. Reflector 16 is parabolic in one exemplary configuration, but may have a different geometry selected to control an illumination angle of light directed onto the flexographic plate. The plasma capillary light source is advantageous for several reasons, such as its instant-on capability, its ability to focus light in a short distance, its efficiency, etc.

In some embodiments, it is useful to be able to dynamically control an intensity of the light provided by light sources 14. This control is readily achievable by the plasma capillary lamp described above, simply by connecting control system 24 to lamp 18 and operating control system 18 to adjust the light intensity output by lamp 18.

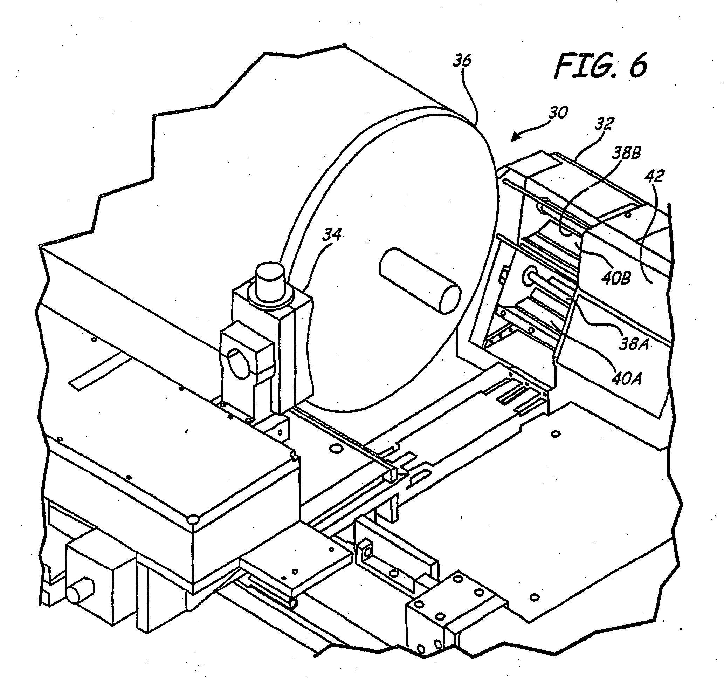

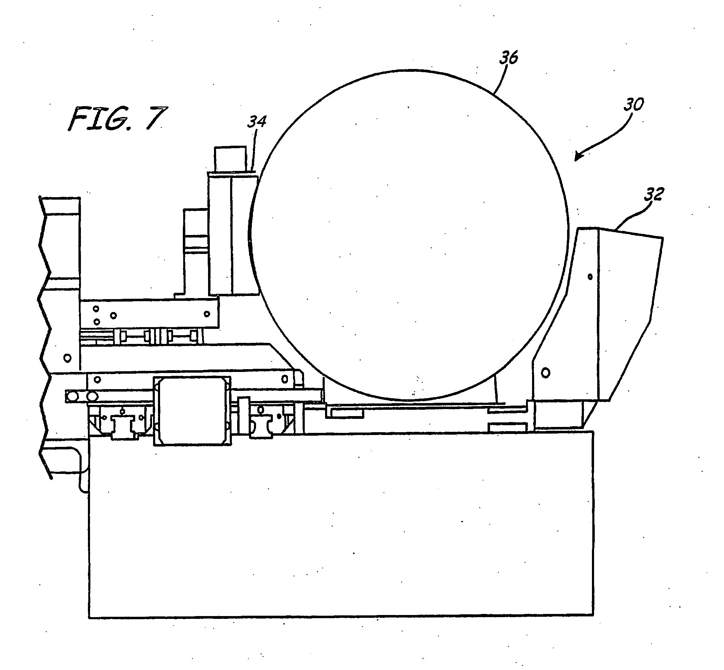

FIG. 6 is a perspective diagram, and FIG. 7 is a side view, of combined ablation and exposure system 30. Light source housing 32 and ablating engine 34 are mounted adjacent to rotatable cylinder 36 on which a flexographic plate is mounted, and are linearly movable along the length of cylinder 36. Light source housing 32 houses high intensity light sources 38A and 38B and their respective reflectors 40A and 40B. Shutter 42 is provided for selectively blocking light from exiting light source housing 32.

In operation, ablating engine 34 and light source housing 32 are linearly moved together along the length of the flexographic plate mounted on rotatable cylinder 36, while cylinder 36 is rotated. The relative locations of ablating engine 34 and light source housing 32 cause each point on the flexographic plate to first be ablated by ablating engine 34, and then exposed by high intensity light generated by light sources 38A and 38B and reflected onto the flexographic plate by reflectors 40A and 40B. In an example, light sources 38A and 38B are 5000 Watt Mercury (or another suitable element) plasma capillary light sources as described above with respect to the first embodiment, and light source housing 32 is provided with liquid cooling to carry away excess heat produced by the light sources. From the perspective of a particular point on the flexographic plate, high intensity light is provided from high intensity light sources 38A and 38B in a relatively large area during rotation of cylinder 36, due to the provision of multiple light sources and the size of the illumination region of each of light sources 38A and 38B as reflected by reflectors 40A and 40B. The large exposure area is important to avoid the problems of latency and excessive power density that were experienced by prior systems, and typically an exposure area of greater than about 100 square centimeters is desirable. Light sources 38A and 38B are also located a very short distance, such as about 25-37 millimeters (mm) (and no greater than about 50 mm) in an example, from rotatable cylinder 36 (and the flexographic plate mounted thereon), due to the geometry of the plasma capillary light sources that are employed. The use of plasma capillary light sources allows a high amount of power of actinic radiation (such as about 700 Watts in one exemplary embodiment) to be delivered to a large area (such as about 230 square centimeters in one exemplary embodiment). This combination provides the high power needed to quickly and effectively expose the photopolymer, so that productivity rates achievable by the system are high, while limiting the power density to about 3 Watts per square centimeter or less so that the photopolymer is not damaged by excessive power. In addition, the problems of latency experienced by prior art systems that exposed points on a flexographic plate with a low duty cycle pulsing light pattern are avoided as well.

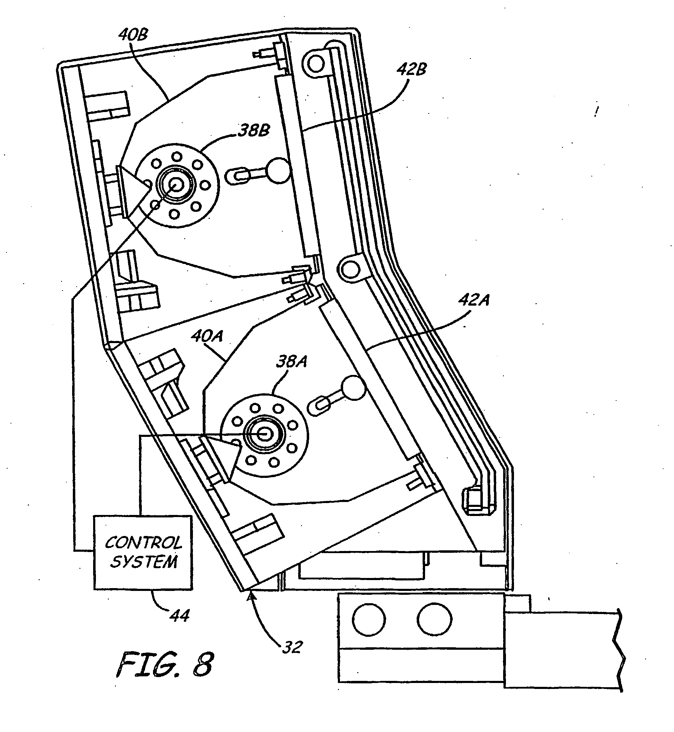

FIG. 8 is a diagram illustrating light source housing 32 and the light source components used in the combined ablation and exposure system shown in FIGS. 6 and 7. High intensity light sources 38A and 38B are plasma capillary light sources that emit light in an essentially omnidirectional manner. The light emitted by high intensity light sources 38A and 38B is reflected by reflectors 40A and 40B out of output apertures 42A and 42B (which may include a protective window of some kind). In an example, reflectors 40A and 40B are coated with a dichroic coating, so that only useful, actinic (ultraviolet) radiation is reflected. Reflectors 40A and 40B are configured in an approximately elliptical shape, but have discrete straight portions rather than a continuously curved shape, in orderto provide discrete illumination angles for the most effective exposure of the flexographic plate.

It is useful to be able to dynamically control an intensity of the light provided by light sources 38A and 38B. This control is readily achievable by the plasma capillary lamp described above, simply by connecting control system 44 to light sources 38A and 38B and operating control system 44 to adjust the light intensity output by light sources 38A and 38B.

The present invention provides an exposure system that is usable in combination with an ablation system to expose an ablated, rotating flexographic photopolymer plate. The exposure system has light output provided by one or more plasma capillary light sources. This system provides a high degree of efficiency in its ability to ablate and expose a photopolymer in an integrated process, and also provides very effective exposure by ensuring that the plate is exposed with high intensity light in a field broad enough to avoid the effects of latency and excessive power density, as opposed to exposure that occurs in a low duty cycle pulsing pattern or smaller exposure areas.

## Claims

1. A system (10) for exposing a photopolymer with ultraviolet light, comprising:
a rotation system (20) for rotating the photopolymer;
an ablating engine (22) adjacent to the rotation system; and
a light source assembly (14) adjacent to the rotation system,
wherein the ablating engine (22) and the light source assembly (14) are movable across a length of the rotation system (20) perpendicular to a direction of rotation of the rotation system, the ablating engine (22) being arranged to lead the light source assembly (14) so that exposure by the light source assembly follows ablation by the ablating engine;
**characterized by**:
the light source assembly (14) including at least one plasma capillary light source (18) for directing light onto the photopolymer is configured with a toroidal geometry around the rotation system (20), having a plurality of light outputs directed toward the rotation system inside the toroidal geometry, so that all points of the photopolymer are continuously exposed.

2. The system of claim 1, wherein the at least one light source (18) is located adjacent to a reflector (16) coated with a dichroic coating that reflects only actinic radiation.

3. The system of claim 1, wherein the at least one light source (18) is located adjacent to a reflector (16) that has a geometry selected to control an illumination angle of light directed onto the photopolymer.

4. The system of claim 3, wherein the reflector (16) has a plurality of discrete straight walls.

5. The system of claim 1, wherein the light source assembly (14) includes a liquid cooled body (12) supporting the at least one light source (18).

6. The system of claim 1, further comprising:
a control system (24) coupled to the at least one light source (18) for dynamically controlling an intensity of the at least one light source.

7. The system of claim 1, wherein the photopolymer is a printing plate, and the rotation system (20) is a rotatable drum on which the printing plate is mounted.

8. The system of claim 1, wherein the photopolymer is a cylindrical printing sleeve that is rotatable by the rotation system (20).

9. The system of claim 1, wherein the light source assembly is spaced from the photopolymer rotation system by no more than 50 millimeters.

10. The system of claim 1, wherein the at least one plasma capillary light source (18) of the light source assembly produces an exposure area of at least 100 square centimeters, and delivers no less than about 700 Watts of actinic radiation to the photopolymer in the area of exposure with a power density of no greater than about 3 Watts per square centimeter.

11. A method of exposing a photopolymer with ultraviolet light, comprising:
rotating the photopolymer; and
directing light from a light source assembly (14) onto the photopolymer from at least one plasma capillary light source (18); and
moving the light source assembly across a length of the photopolymer perpendicular to a direction of rotation of the photopolymer to expose the photopolymer;
**characterized by**:
directing the light from the light source assembly onto the photopolymer comprises directly the light from a plurality of light outputs so that all points of the photopolymer are continuously exposed.

12. The method of claim 11, wherein directing light from the light source assembly (14) onto the photopolymer comprises energizing a plurality of plasma capillary light sources (18) surrounding the photopolymer.

13. The method of claim 11, wherein the at least one light source (18) is located adjacent a reflector (16) coated with a dichroic coating that reflects only actinic radiation.

14. The method of claim 13, wherein the reflector (16) has a geometry selected to control an illumination angle of light directed onto the photopolymer.

15. The method of claim 14, wherein the reflector (16) has a plurality of discrete straight walls.

16. The method of claim 11 further comprising liquid cooling the light source assembly (14).

17. The method of claim 11, further comprising dynamically controlling an intensity of the light provided by the light source assembly to control exposure of the photopolymer.

## Patentansprüche

1. System (10) zum Belichten eines Fotopolymers mit ultraviolettem Licht, das Folgendes umfasst:
ein Rotationssystem (20) zum Drehen des Fotopolymers;
eine Ablationsvorrichtung (22) neben dem Rotationssystem; und
eine Lichtquellenbaugruppe (14) neben dem Rotationssystem,
wobei die Ablationsvorrichtung (22) und die Lichtquellenbaugruppe (14) über eine Länge des Rotationssystems (20) lotrecht zu einer Drehrichtung des Rotationssystems beweglich sind, wobei die Ablationsvorrichtung (22) so ausgelegt ist, dass sie sich immer so vor der Lichtquellenbaugruppe (14) befindet, dass auf die Belichtung durch die Lichtquellenbaugruppe eine Ablation durch die Ablationsvorrichtung folgt;
**dadurch gekennzeichnet, dass**
die Lichtquellenbaugruppe (14), die wenigstens eine Plasmakapillare-Lichtquelle (18) zum Richten von Licht auf das Fotopolymer hat, mit einer Torusgeometrie um das Rotationssystem (20) konfiguriert ist, wobei mehrere Lichtausgänge auf das Rotationssystem innerhalb der Torusgeometrie gerichtet sind, so dass alle Punkte des Fotopolymers kontinuierlich belichtet werden.

2. System nach Anspruch 1, wobei sich die wenigstens eine Lichtquelle (18) neben einem Reflektor (16) befindet, der mit einem dichroitischen Überzug beschichtet ist, der nur aktinische Strahlung reflektiert.

3. System nach Anspruch 1, wobei sich die wenigstens eine Lichtquelle (18) neben einem Reflektor (16) befindet, der eine Geometrie hat, die so gewählt ist, dass ein Beleuchtungswinkel von auf das Fotopolymer gerichtetem Licht geregelt wird.

4. System nach Anspruch 3, wobei der Reflektor (16) mehrere diskrete gerade Wände hat.

5. System nach Anspruch 1, wobei die Lichtquellenbaugruppe (14) einen flüssigkeitsgekühlten Körper (12) hat, der die wenigstens eine Lichtquelle (18) trägt.

6. System nach Anspruch 1, das ferner Folgendes umfasst:
ein Steuersystem (24), das mit der wenigstens einen Lichtquelle (18) gekoppelt ist, um eine Intensität der wenigstens einen Lichtquelle dynamisch zu regeln.

7. System nach Anspruch 1, wobei das Fotopolymer eine Druckplatte ist und das Rotationssystem (20) eine rotationsfähige Trommel ist, auf der die Druckplatte montiert ist.

8. System nach Anspruch 1, wobei das Fotopolymer eine Druckzylinderhülse ist, die von dem Rotationssystem (20) gedreht werden kann.

9. System nach Anspruch 1, wobei die Lichtquellenbaugruppe von dem Fotopolymerrotationssystem um maximal 50 Millimeter beabstandet ist.

10. System nach Anspruch 1, wobei die wenigstens eine Plasmakapillare-Lichtquelle (18) der Lichtquellenbaugruppe eine Belichtungsfläche von wenigstens 100 Quadratzentimetern erzeugt und mindestens etwa 700 Watt an aktinischer Strahlung auf das Fotopolymer im Belichtungsbereich mit einer Leistungsdichte von maximal etwa 3 Watt pro Quadratzentimeter liefert.

11. Verfahren zum Belichten eines Fotopolymers mit ultraviolettem Licht, das Folgendes beinhaltet:
Drehen des Fotopolymers, und
Richten von Licht von einer Lichtquellenbaugruppe (14) auf das Fotopolymer von wenigstens einer Plasmakapillare-Lichtquelle (18); und
Bewegen der Lichtquellenbaugruppe über eine Länge des Fotopolymers lotrecht zu einer Rotationsrichtung des Fotopolymers, um das Fotopolymer zu belichten;
**dadurch gekennzeichnet, dass**:
das Richten des Lichts von der Lichtquellenbaugruppe auf das Fotopolymer das Richten des Lichts von mehreren Lichtausgängen beinhaltet, so dass alle Punkte des Fotopolymers kontinuierlich belichtet werden.

12. Verfahren nach Anspruch 11, wobei das Richten von Licht von der Lichtquellenbaugruppe (14) auf das Fotopolymer das Anregen mehrerer Plasmakapillare-Lichtquellen (18) beinhaltet, die das Fotopolymer umgeben.

13. Verfahren nach Anspruch 11, wobei sich die wenigstens eine Lichtquelle (18) neben einem Reflektor (16) befindet, der mit einem dichroitischen Überzug beschichtet ist, der nur aktinische Strahlung reflektiert.

14. Verfahren nach Anspruch 13, wobei der Reflektor (16) eine Geometrie hat, die so gewählt ist, dass ein Beleuchtungswinkel von auf das Fotopolymer gerichtetem Licht geregelt wird.

15. Verfahren nach Anspruch 14, wobei der Reflektor (16) mehrere diskrete gerade Wände hat.

16. Verfahren nach Anspruch 11, das ferner das Flüssigkeitskühlen der Lichtquellenbaugruppe (14) beinhaltet.

17. Verfahren nach Anspruch 11, das ferner das dynamische Regeln einer Intensität des von der Lichtquellenbaugruppe bereitgestellten Lichts beinhaltet, um die Belichtung des Fotopolymers zu regeln.

## Revendications

1. Système (10) permettant d'exposer un photopolymère à la lumière ultraviolette, comportant :
un système de rotation (20) à des fins de mise en rotation du photopolymère ;
un moteur d'ablation (22) adjacent au système de rotation ; et
un ensemble de source lumineuse (14) adjacent au système de rotation,
dans lequel le moteur d'ablation (22) et l'ensemble de source lumineuse (14) sont mobiles en travers d'une longueur du système de rotation (20) perpendiculaire à une direction de rotation du système de rotation, le moteur d'ablation (22) étant arrangé pour mener l'ensemble de source lumineuse (14) de sorte que l'exposition par l'ensemble de source lumineuse suit l'ablation par le moteur d'ablation ;
**caractérisé en ce que** :
l'ensemble de source lumineuse (14) comprenant au moins une source lumineuse capillaire à plasma (18) permettant de diriger la lumière sur le photopolymère est configuré selon une géométrie toroïdale autour du système de rotation (20), ayant une pluralité de sorties lumineuses dirigées vers le système de rotation à l'intérieur de la géométrie toroïdale, de sorte que tous les points du photopolymère sont exposés de manière continue.

2. Système selon la revendication 1, dans lequel ladite au moins une source lumineuse (18) est située de manière adjacente à un réflecteur (16) revêtu d'un revêtement dichroïque qui réfléchit uniquement le rayonnement actinique.

3. Système selon la revendication 1, dans lequel ladite au moins une source lumineuse (18) est située de manière adjacente à un réflecteur (16) qui a une géométrie sélectionnée pour contrôler un angle d'illumination de la lumière dirigée sur le photopolymère.

4. Système selon la revendication 3, dans lequel le réflecteur (16) a une pluralité de parois droites discrètes.

5. Système selon la revendication 1, dans lequel l'ensemble de source lumineuse (14) comprend un corps refroidi par liquide (12) supportant ladite au moins une source lumineuse (18).

6. Système selon la revendication 1, comportant par ailleurs :
un système de contrôle (24) accouplé à ladite au moins une source lumineuse (18) pour contrôler de manière dynamique une intensité de ladite au moins une source lumineuse.

7. Système selon la revendication 1, dans lequel le photopolymère est une plaque d'impression, et le système de rotation (20) est un tambour rotatif sur lequel la plaque d'impression est montée.

8. Système selon la revendication 1, dans lequel le photopolymère est un manchon d'impression cylindrique qui est en mesure d'être mis en rotation par le système de rotation (20).

9. Système selon la revendication 1, dans lequel l'ensemble de source lumineuse est espacé par rapport au système de rotation du photopolymère de 50 millimètres au plus.

10. Système selon la revendication 1, dans lequel ladite au moins une source lumineuse capillaire à plasma (18) de l'ensemble de source lumineuse produit une surface d'exposition d'au moins 100 centimètres carrés et procure pas moins d'environ 700 Watts de rayonnement actinique au photopolymère dans la zone d'exposition avec un éclairement de puissance ne faisant pas plus d'environ 3 Watts par centimètre carré.

11. Procédé permettant d'exposer un photopolymère à la lumière ultraviolette, comportant :
la mise en rotation du photopolymère ; et
la direction de la lumière depuis un ensemble de source lumineuse (14) sur le photopolymère à partir d'au moins une source lumineuse capillaire à plasma (18); et
le déplacement de l'ensemble de source lumineuse en travers d'une longueur du photopolymère perpendiculaire à une direction de rotation du photopolymère pour exposer le photopolymère ;
**caractérisé en ce que** :
la direction de la lumière depuis l'ensemble de source lumineuse sur le photopolymère comporte la direction de la lumière depuis une pluralité de sorties lumineuses de sorte que tous les points du photopolymère sont exposés de manière continue.

12. Procédé selon la revendication 11, dans lequel la direction de la lumière depuis l'ensemble de source lumineuse (14) sur le photopolymère comporte l'excitation d'une pluralité de sources lumineuses capillaires à plasma (18) entourant le photopolymère.

13. Procédé selon la revendication 11, dans lequel ladite au moins une source lumineuse (18) est située de manière adjacente à un réflecteur (16) revêtu d'un revêtement dichroïque qui réfléchit uniquement le rayonnement actinique.

14. Procédé selon la revendication 13, dans lequel le réflecteur (16) a une géométrie sélectionnée pour contrôler un angle d'illumination de la lumière dirigée sur le photopolymère.

15. Procédé selon la revendication 14, dans lequel le réflecteur (16) a une pluralité de parois droites discrètes.

16. Procédé selon la revendication 11, comportant par ailleurs un liquide refroidissant l'ensemble de source lumineuse (14).

17. Procédé selon la revendication 11, comportant par ailleurs le contrôle dynamique d'une intensité de la lumière que procure l'ensemble de source lumineuse pour contrôler l'exposition du photopolymère.
